**Europäisches Patentamt**

**European Patent Office**

**Office européen des brevets**

(19)

(11) Numéro de publication : **0 500 434 A1**

# (12) DEMANDE DE BREVET EUROPEEN

(21) Numéro de dépôt : **92400406.2**

(22) Date de dépôt : **14.02.92**

(51) Int. Cl.⁵ : **H03F 3/72, H03F 3/191**

(30) Priorité : **18.02.91 FR 9101889**

(43) Date de publication de la demande :
**26.08.92 Bulletin 92/35**

(84) Etats contractants désignés :
**AT BE CH DE DK ES GB GR IT LI LU NL PT SE**

(71) Demandeur : **MATRA COMMUNICATION**
**50, rue du Président Sadate Creac'h Gwenn**
**F-29101 Quimper (FR)**

(72) Inventeur : **Jolivet, André**
**10ter rue Madame**
**F-78000 Versailles (FR)**
Inventeur : **Buisson, Pierre**
**8 rue du Midi**
**F-94000 Arcueil (FR)**

(74) Mandataire : **Fruchard, Guy et al**
**CABINET BOETTCHER 23, rue la Boétie**
**F-75008 Paris (FR)**

(54) **Module d'amplification bibande.**

(57) Le module d'amplification selon l'invention comporte un premier et un second amplificateur (1,2) adaptés à amplifier respectivement une première et une seconde bandes de fréquences et comportant chacun un transistor (3), un circuit de polarisation comprenant une source de polarisation (6), un organe d'interruption (7) disposé dans les circuits de polarisation et un premier et second circuits de blocage de sortie (8) disposé entre la source de polarisation (6) et un amplificateur pour bloquer en sortie l'amplificateur dont l'organe d'interruption du circuit de polarisation est ouvert.

La présente invention concerne un module d'amplification bibande et plus particulièrement, bien que non exclusivement, un module d'amplification destiné à être implanté dans un mobile de radiotéléphonie afin d'amplifier alternativement les signaux de l'une de deux bandes de fonctionnement de ce mobile.

On sait que le nombre d'utilisateurs pouvant communiquer entre eux au sein d'un réseau de radiocommunication fonctionnant dans une bande de fréquences est limité. Afin d'augmenter le nombre d'utilisateurs pouvant entrer en communication les uns avec les autres, en particulier dans les zones à très forte densité de passage telles que les zones urbaines,on a envisagé des réseaux de radiotéléphonie fonctionnant dans deux bandes de fréquences distinctes, un utilisateur pouvant s'inscrire, de façon manuelle ou automatique, dans l'une des bandes de fréquence en fonction de l'encombrement de chacune des bandes de fréquences au moment de l'arrivée de l'utilisateur dans la zone considérée. A chaque bande de fréquences, il est nécessaire d'associer un amplificateur adapté à amplifier cette bande de fréquences. Toutefois, pour éviter une multiplication de composants qui entraîneraient un encombrement et un coût prohibitifs, on prévoit d'associer les deux amplificateurs à un même circuit de traitement par l'intermédiaire d'un mélangeur. Cependant, il est nécessaire d'éviter les interférences possibles entre les signaux amplifiés dans chacune des deux bandes de fréquences et lorsque l'un des modules d'amplification fonctionnant dans une fréquence est en service, il est nécessaire d'assurer un blocage aussi parfait que possible du module d'amplification fonctionnant dans l'autre bande de fréquences.

Pour celà on propose selon l'invention un module d'amplification bibande comportant un premier et un second amplificateurs adaptés à amplifier respectivement une première et une seconde bandes de fréquences et comportant chacun un transistor, un circuit d'adaptation d'entrée, un circuit de polarisation comprenant une source de polarisation, un organe d'interruption disposé dans le circuit de polarisation, un circuit d'adaptation de sortie, et un filtre passe-bande disposé en aval du circuit d'adaptation de sortie ; un premier et un second circuits de blocage de sortie comprenant chacun une première diode PIN en série dans la ligne de sortie d'un amplificateur entre le circuit d'adaptation de sortie et le filtre passe-bande, et une seconde diode PIN montée en parallèle à la première diode PIN en aval de celle-ci, et associée à un condensateur de découplage, les diodes PIN du premier et du second circuit de blocage de sortie ayant une borne d'entrée respectivement reliée à la source de polarisation du second et du premier amplificateur, et la seconde diode PIN du premier et du second circuit de blocage de sortie ayant une borne de sortie respectivement reliée à l'organe d'interruption du circuit de polarisation du second et du premier amplificateur ; et une source de tension de référence reliée à chaque amplificateur entre le transistor et le circuit d'adaptation de sortie d'une part, et entre l'organe d'interruption du circuit de polarisation et la seconde diode PIN du circuit de blocage de sortie correspondant d'autre part.

Ainsi, on assure non seulement la polarisation de l'un des amplificateurs et la coupure de polarisation de l'autre amplificateur, mais également le blocage positif de la sortie de l'amplificateur qui n'est pas en fonctionnement.

Selon une version avantageuse de l'invention, le premier et le second circuits de blocage de sortie sont reliés à une source de polarisation commune aux deux amplificateurs disposée en parallèle aux deux circuits de blocage de sortie entre les bornes d'entrée de ceux-ci. Ainsi, la tension qui assure le blocage de l'un des circuits de blocage de sortie assure simultanément la polarisation de l'amplificateur associé à l'autre circuit de blocage de sortie de sorte que l'on minimise l'encombrement et la consommation globale du dispositif.

Selon un autre aspect avantageux de l'invention, chaque circuit d'adaptation de sortie comporte des moyens assurant un couplage en courant continu entre le transistor et le circuit de blocage de sortie correspondant. Ainsi la tension de collecteur du transistor est maintenue à un niveau élevé de sorte que l'on assure une capacité de couplage faible au niveau de la liaison base-collecteur du transistor et par conséquent une forte atténuation des perturbations pouvant survenir.

Selon encore un autre aspect avantageux de l'invention, les filtres passe-bande des deux amplificateurs sont reliés l'un à l'autre en parallèle, le filtre passe-bande associé au premier amplificateur a une impédance très élevée à l'égard de signaux aux fréquences de passage du filtre passe-bande associé au second amplificateur, et le filtre passe-bande associé au second amplificateur comporte une ligne d'adaptation d'impédance ayant une longueur réalisant une impédance très faible à l'égard de signaux aux fréquences de fonctionnement du second amplificateur et une impédance très forte à l'égard de signaux aux fréquences de fonctionnement du premier amplificateur. Ainsi, indépendamment du blocage des transistors, on évite que des signaux provenant de la ligne qui n'est pas en fonctionnement ne viennent interférer avec les signaux de la ligne en fonctionnement.

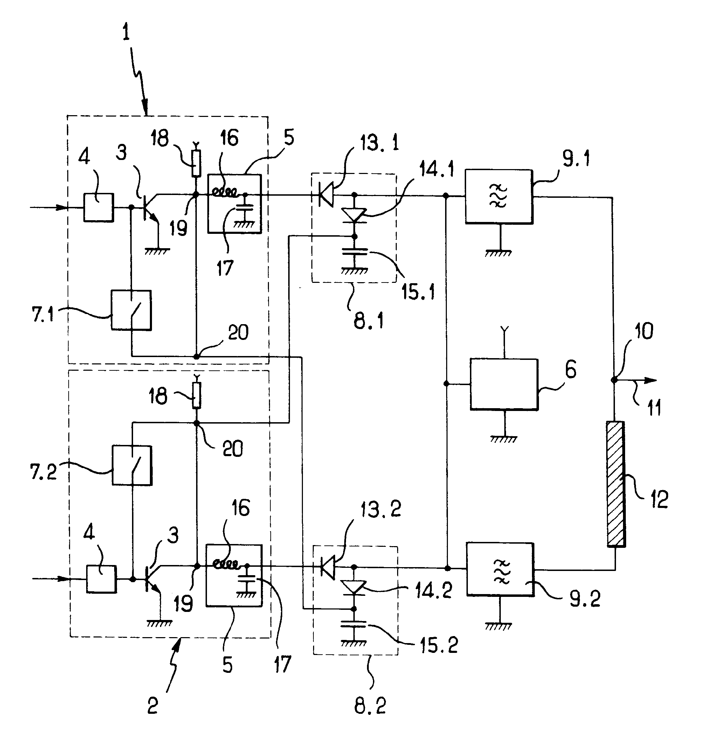

D'autres caractéristiques et avantages de l'invention ressortiront à la lecture de la description qui suit d'un mode de réalisation particulier non limitatif de l'invention en liaison avec la figure unique ci-joint qui est une représentation schématique de l'invention.

En référence au dessin, le module d'amplification bibande selon l'invention comporte un premier amplificateur généralement désigné en 1 et un second amplificateur généralement désigné en 2. Le premier amplificateur est par exemple destiné à amplifier des signaux dans une bande de fréquences voisines de 900 MHz et le second amplificateur est destiné à amplifier des signaux dans une bande de fréquences voisines de 400 MHz.

Chaque amplificateur comporte un transistor 3 dont la base est reliée à un circuit d'adaptation d'entrée 4 lui-même relié à la borne d'entrée de l'amplificateur. L'émetteur du transistor 3 est relié à la masse et le collecteur est relié à un circuit d'adaptation de sortie 5. Le circuit d'adaptation de sortie 5 est de préférence du type assurant un couplage en courant continu et comporte par exemple à cet effet une inductance série 16 associée à un condensateur de découplage alternatif 17 monté en parallèle et relié à la masse. La base du transistor 3 est également reliée à une source de polarisation commune 6 par l'intermédiaire d'un organe d'interruption désigné de façon générale en 7 et plus particulièrement en 7.1 pour l'amplificateur 1 et en 7.2 pour l'amplificateur 2, cette numérotation particulière étant adoptée par la suite pour les composants qui sont semblables dans chacune des lignes d'amplification et qu'il est cependant nécessaire de distinguer par la clarté des explications. L'organe d'interruption 7 est d'un type quelconque, mécanique ou électrique, en particulier il peut être constitué par un transistor commandé à distance par un centre de gestion des communications au moment où un utilisateur s'inscrit dans une zone. Un circuit de blocage de sortie 8 dont la structure va être détaillée ci-dessous est également monté dans le circuit de polarisation entre l'organe d'interruption 7 et la source de polarisation 6.

Au-delà du circuit de blocage de sortie 8, chaque ligne d'amplification comporte un filtre passe-bande généralement désigné en 9 et identifié de façon plus précise avec la référence numérique 9.1 pour le filtre passe-bande associé à l'amplificateur 1, et 9.2 pour le filtre passe-bande associé l'amplificateur 2. Le filtre passe-bande 9.1 est d'un type connu en soi ayant une impédance élevée pour des signaux compris dans une bande de fréquences de fonctionnement de l'amplificateur 2 et est relié directement à un point commun 10 lui-même relié à un mélangeur, non représenté, par une ligne 11.

Par ailleurs, le filtre passe-bande 9.2 est relié au point commun 10 par l'intermédiaire d'une ligne 50 ohms, connue en elle-même, ayant une longueur telle que son impédance apparente est très faible dans la bande de fréquences de fonctionnement de l'amplificateur 2 et son impédance apparente est au contraire très élevée dans la bande de fréquences de fonctionnement de l'amplificateur 1.

Chaque circuit de blocage 8 comporte une première diode PIN 13 en série dans la ligne de sortie de l'amplificateur et ayant une borne d'entrée reliée à la source de polarisation 6, et une seconde diode PIN 14 montée en parallèle à la première diode PIN 13 en aval de celle-ci et associée à un condensateur de découplage 15 lui-même relié à la masse. La diode PIN 14.1 a sa sortie reliée à l'organe d'interruption 7.2 de l'amplificateur 2 tandis que la diode PIN 14.2 a sa sortie reliée à l'organe d'interruption 7.1 de l'amplificateur 1.

Par ailleurs, une source de tension de référence 18 est reliée par l'intermédiaire d'une résistance élevée à chaque circuit d'amplification d'une part en un point 19 entre le collecteur du transistor 3 et le circuit d'adaptation 5 correspondant, et d'autre part en un point 20 disposé entre l'organe d'interruption 7 et la seconde diode PIN 14 qui lui est associée. Les tensions respectives de la source de tension de référence 18 et de la source de polarisation 6 sont telles que la tension au point commun des deux diodes PIN 13 et 14 soit inférieure à la valeur de la tension de référence.

Le fonctionnement du dispositif selon l'invention est le suivant : en supposant que l'organe d'interruption 7.1 soit fermé et l'organe d'interruption 7.2 soit ouvert, le transistor 3 de l'amplificateur 2 n'est pas polarisé et est donc bloqué. Simultanément, la diode PIN 13.2 est bloquée en raison de la différence de potentiel à ses bornes tandis que la diode PIN 14.2 conduit, ce qui permet de polariser le transistor 3 de l'amplificateur 1. Ceci entraîne un abaissement de la tension de collecteur du transistor 3 de l'amplificateur 1 et, par voie de conséquence, la conduction de la diode PIN 13.1 tandis que la diode PIN 14.1 se trouve au contraire bloquée par la différence de tension entre le point 20 et la tension résultant de la source de polarisation 6. Les signaux dans une bande de fréquences voisine de 900 MHz sont donc transmis par la première ligne d'amplification et traversent le filtre passe-bande 9.1. A cette fréquence, la ligne 50 ohms 12 apparaît avec une impédance très élevée et les signaux reçus sont donc transmis au dispositif de traitement par la ligne 11.

Bien entendu l'invention n'est pas limitée au mode de réalisation décrit et on peut y apporter des variantes de réalisation sans sortir du cadre de l'invention.

En particulier, bien que dans le mode de réalisation illustré la source de polarisation soit de préférence commune aux deux amplificateurs, on peut prévoir des sources de polarisation séparées chacune reliée à une ligne d'amplification entre le circuit de blocage et le circuit passe-bande. Le fonctionnement du dispositif d'amplification restera exactement le même. Dans ce cas on remarquera que la polarisation du premier amplificateur passe toujours par le second circuit de blocage de sortie tandis que la polarisation du second amplificateur passe par le premier circuit de blocage de sortie. A la sortie du module d'amplification on peut également prévoir des systèmes de couplage de ligne plus complexes que celui qui a été décrit.

## Revendications

1. Module d'amplification bi-bande caractérisé en ce qu'il comporte un premier et un second amplificateur (1,2) adaptés à amplifier respectivement une première et une seconde bandes de fréquences et comportant chacun un transistor (3), un circuit d'adaptation d'entrée (4), un circuit de polarisation comprenant une source de polarisation (6), un organe d'interruption (7) disposé dans les circuits de polarisation, un circuit d'adaptation de sortie (5), et un filtre passe-bande (9) disposé en aval du circuit d'adaptation de sortie ; un premier et second circuits de blocage de sortie (8) comprenant chacun une première diode PIN (13) en série dans la ligne de sortie d'un amplificateur entre le circuit d'adaptation de sortie (5) et le filtre passe-bande (9), et une seconde diode PIN (14) montée en parallèle à la première diode PIN (13) en aval de celle-ci, et associée à un condensateur de découplage (1), les diodes PIN du premier et du second circuits de blocage de sortie ayant une borne d'entrée respectivement reliée à la source de polarisation du second et du premier amplificateur, et la seconde diode PIN (14.1, 14.2) du premier et du second circuit de blocage de sortie ayant une borne de sortie respectivement reliée à l'organe d'interruption (7.2, 7.1) du circuit de polarisation du second et du premier amplificateurs ; et une source de tension de référence (18) reliée à chaque amplificateur entre le transistor (3) et le circuit d'adaptation de sortie (5) d'une part, et entre l'organe d'interruption (7) du circuit de polarisation et la seconde diode PIN du circuit de blocage de sortie correspondant d'autre part.

2. Module d'amplification bi-bande selon la revendication 1, caractérisé en ce que le premier et le second circuits de blocage de sortie sont reliés à une source de polarisation (6) commune aux deux amplificateurs disposée en parallèle aux deux circuits de blocage de sortie entre les bornes d'entrée de ceux-ci.

3. Module d'amplification bi-bande selon la revendication 1 ou la revendication 2, caractérisé en ce que chaque circuit d'adaptation de sortie (5) comporte des moyens (16) assurant un couplage en courant continu entre le transistor et le circuit de blocage de sortie correspondant.

4. Module d'amplification bi-bande selon l'une quelconque des revendications 1 à 3 caractérisé en ce que les filtres passe-bande (9) des deux amplificateurs sont reliés l'un à l'autre en parallèle, en ce que le filtre passe-bande associé au premier amplificateur à une impédance très élevée à l'égard de signaux aux fréquences de passage du filtre passe-bande associé au second amplificateur, en ce que le filtre passe-bande associé au second amplificateur comporte une ligne d'adaptation d'impédance (12) ayant une impédance très faible à l'égard de signaux aux fréquences de fonctionnement du second amplificateur et une impédance très forte à l'égard de signaux aux fréquences de fonctionnement du premier amplificateur.

Office européen
des brevets

**RAPPORT DE RECHERCHE EUROPEENNE**

Numero de la demande

EP    92 40 0406

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 608 862 (LA RADIOTECHNIQUE INDUSTRIELLE ET COMMERCIALE.)<br>* page 4, ligne 8 - page 8, ligne 4; figures 4-6 *<br>--- | 1-3 | H03F3/72<br>H03F3/191 |
| A | EP-A-0 177 103 (INTERNATIONAL STANDARD ELECTRIC CORPORATION)<br>* page 4, ligne 3 - page 7, ligne 37; figures 1-3 *<br>--- | 1,3 | |
| A | EP-A-0 128 631 (PHILIPS PATENTVERWALTUNG GMBH)<br>* page 4, ligne 1 - page 7, ligne 6; figure *<br>----- | 1,2 | |

**DOMAINES TECHNIQUES RECHERCHES (Int. Cl.5)**

H03F

Le présent rapport a été établi pour toutes les revendications

| Lieu de la recherche | Date d'achèvement de la recherche | Examinateur |
|---|---|---|
| LA HAYE | 18 MAI 1992 | TYBERGHIEN G.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P0402)